# EUROPEAN PATENT APPLICATION

(11) **EP 4 593 084 A1**
(43) Date of publication of application: **30.07.2025**
(21) Application number: 22962141.2
(22) Date of filing: 11.10.2022
(51) Int. Cl.: H01L 27/15, H01L 25/075, H01L 27/12, H01L 33/40

(54) **DISPLAY DEVICE COMPRISING SEMICONDUCTOR LIGHT-EMITTING ELEMENT**

(71) Applicant: LG Electronics Inc., Yeongdeungpo-gu Seoul 07336 (KR); LG Display Co., Ltd., Seoul, 07336 (KR)
(72) Inventor: YANG, Dohwan, Seoul 06772 (KR); CHUNG, Indo, Seoul 06772 (KR); KIM, Youngdo, Seoul 06772 (KR)
(74) Representative: Vossius & Partner Patentanwälte Rechtsanwälte mbB
(86) International application number: PCT/KR2022/015273
(87) International publication number: WO 2024/080390

(57) **Abstract**

The embodiment relates to a display device including a semiconductor light emitting device.

A display device including a semiconductor light emitting device according to the embodiment comprises a substrate, first assembly electrodes and second assembly electrodes spaced apart from each other on the substrate, a first polarity zeta potential insulating layer disposed on the first and second assembly electrodes, an assembly partition having an assembly hole disposed on the first and second assembly electrodes, and a semiconductor light emitting device disposed within the assembly hole, wherein the semiconductor light emitting device may include a metal layer having a second polarity zeta potential.

## Description

### [Technical field]

The embodiment relates to a display device including a semiconductor light emitting device.

### [Background Art]

Large-area displays (including liquid crystal displays (LCDs), OLED displays, and micro-LED displays).

Micro-LED displays are displays that use micro-LEDs, semiconductor light emitting devices with a diameter or cross-sectional area of 100*µ*m or less, as display elements.

Micro-LED displays have excellent performance in many characteristics such as contrast ratio, response speed, color reproducibility, viewing angle, brightness, resolution, lifespan, luminous efficiency, and luminance because they use micro-LEDs, semiconductor light emitting devices, as display elements.

In particular, micro-LED displays have the advantage of being able to freely adjust the size or resolution because the screen can be separated and combined in a modular manner, and the advantage of being able to implement a flexible display.

However, since large-area micro-LED displays require millions or more micro-LEDs, there is a technical problem that makes it difficult to quickly and accurately transfer micro-LEDs to the display panel.

Transfer technologies that are being developed recently include the pick and place process, the laser lift-off method or self-assembly method.

Among these, the self-assembly method is a method in which semiconductor light emitting devices find their assembly positions on their own in a fluid, and is advantageous for implementing large-screen display devices.

Recently, US Patent No. 9,825,202 presented a micro-LED structure suitable for self-assembly, but research on the technology for manufacturing displays through self-assembly of micro-LEDs is still insufficient.

In particular, in the conventional technology, when rapidly transferring millions or more semiconductor light emitting devices to a large display, the transfer speed can be improved, but there is a technical problem in that the transfer yield is low because the transfer error rate can increase.

Meanwhile, a self-assembly transfer process using dielectrophoresis (DEP) is being attempted in related technologies, but there is a problem in that the self-assembly rate is low due to the unevenness of the DEP force.

Meanwhile, the self-assembly method using the DEP force of the internal technology includes the step of first moving the LED chip to the assembly hole area by the magnetic force of the magnet, and the step of assembling the LED chip in the assembly hole by applying an alternating current to the assembly wiring with the DEP force.

Meanwhile, the LED chip is assembled using the DEP force using a pair of corresponding first and second assembly electrodes in the internal technology, but the DEP force in the assembly hole is not strong, so there is an issue with the assembly rate of the LED chip, and also, an issue has been discovered in the internal study that among the LED chips assembled on the assembly electrode, if the DEP force is weak, they are detached by the magnetic force of the magnet.

In particular, according to the internal technology, a process of draining the fluid in the tank is performed after the assembly using the DEP force. At this time, if the power to the assembly electrode is cut off and there is no DEP force, the fixing force between the semiconductor light emitting device and the dielectric layer on the assembly electrode is weak, so the fluid draining process takes tens of minutes or more, and the problem of the semiconductor light emitting device assembled in the assembly hole being detached occurs.

In addition, in the internal technology, when the electrode process of the panel unit is performed after assembly using the DEP force, if the power is cut off to the assembly electrode and there is no DEP force, the fixing force between the semiconductor light emitting device and the dielectric layer on the assembly electrode is weak, causing a problem in which the semiconductor light emitting device assembled in the assembly hole is detached.

### [Disclosure]

### [Technical Problem]

One of the technical objects of the embodiment is to solve the problem of low self-assembly rate due to non-uniformity of DEP force in the self-assembly method using dielectrophoresis (DEP).

One of the technical objects of the embodiment is to solve the problem of low self-assembly rate due to non-uniformity of DEP force, etc. in the self-assembly method using dielectrophoresis (DEP).

One of the technical objects of the embodiment is to solve the problem of weak fixing force between the semiconductor light emitting device and the dielectric layer on the assembly electrode, causing a problem in which the semiconductor light emitting device assembled in the assembly hole is detached when the power is cut off to the assembly electrode after assembly using the DEP force and there is no DEP force.

One of the technical objects of the embodiment is to solve the problem of weak DEP force in the assembly hole, causing an issue in the assembly rate of the LED chip.

Also, one of the technical objects of the embodiment is to solve the problem that the LED chips assembled on the assembly electrode are separated by the magnetic force of the magnet when the DEP force is weak due to the weak DEP force in the assembly hole.

The technical problem of the embodiment is not limited to what is described in this item, and includes what can be understood throughout the specification.

### [Technical Solution]

A display device including a semiconductor light emitting device according to the embodiment may include a substrate, a first assembly electrode and a second assembly electrode spaced apart from each other on the substrate, a first polarity zeta potential insulating layer disposed on the first and second assembly electrodes, an assembly partition wall disposed with an assembly hole disposed on the first and second assembly electrodes, and a semiconductor light emitting device disposed in the assembly hole, wherein the semiconductor light emitting device may include a metal layer of a second polarity zeta potential.

The first polarity zeta potential insulating layer may include hydrogenated silicon carbide.

The first polarity zeta potential insulating layer (307) may have a positive (+) zeta potential.

The second polarity zeta potential metal layer (132) may have a negative (-) zeta potential.

The first polarity zeta potential insulating layer (307) may have a dielectric constant of 8 to 14.

In addition, a display device including a semiconductor light emitting device according to an embodiment may include a substrate, a first assembly electrode and a second assembly electrode spaced apart from each other on the substrate, a first polarity zeta potential insulating layer disposed on the first and second assembly electrodes, an assembly partition wall disposed with an assembly hole disposed on the first and second assembly electrodes, and a semiconductor light emitting device disposed within the assembly hole, wherein the semiconductor light emitting device may include a second polarity zeta potential insulating layer.

The second polarity zeta potential second insulating layer may include a nitride film or an oxide film.

In the embodiment, the semiconductor light emitting device may further include a metal layer of the second polarity zeta potential.

The second polarity zeta potential second insulating layer may be disposed between the metal layer of the second polarity zeta potential and the first polarity zeta potential insulating layer.

The first polarity zeta potential insulating layer may include hydrogenated silicon carbide.

### [Advantageous Effects]

According to the display device including the semiconductor light emitting device according to the embodiment, when power is cut off to the assembly electrode after assembly using the DEP force and there is no DEP force, the problem of the semiconductor light emitting device assembled in the assembly hole being detached due to the weak fixing force between the semiconductor light emitting device and the dielectric layer on the assembly electrode can be solved.

For example, according to an embodiment, a first polarity zeta potential insulating layer (307) is disposed between the first and second assembly electrodes (310, 320) and the semiconductor light emitting device (150N), and a second polarity zeta potential metal layer (132) is included in the semiconductor light emitting device (150N), so that the fixing force on the first polarity zeta potential insulating layer (307) of the semiconductor light emitting device (150N) can be significantly improved.

For example, the first polarity zeta potential insulating layer (307) can be controlled to have a positive (+) zeta potential and the metal layer can be controlled to have a negative (-) zeta potential, so that the value of the overall zeta potential can be controlled to be close to zero. Accordingly, the semiconductor light emitting device (150N) can be condensed on the first polarity zeta potential insulating layer (307), so that the fixing force between them can be significantly improved.

In addition, according to the embodiment, the dielectric constant of the first polarity zeta potential insulating layer (307) disposed on the first and second assembly electrodes (310, 320) is set to be at least twice as high as that of a conventional insulating film, thereby significantly improving the DEP force, thereby significantly improving the positive assembly rate, and further, by controlling the first polarity zeta potential insulating layer (307) to have a positive (+) zeta potential and the metal layer to have a negative (-) zeta potential, the semiconductor light emitting device (150N) is aggregated on the first polarity zeta potential insulating layer (307), thereby significantly improving the fixing force between them, thereby providing a composite technical effect.

In addition, in the embodiment, the dielectric constant of the first polarity zeta potential insulating layer (307) disposed on the first and second assembly electrodes (310, 320) can be at least twice as high as that of a conventional insulating film such as SiO₂. For example, the dielectric constant of the first polarity zeta potential insulating layer (307) in the example can be about 8 to 14, which is more than twice as high as the dielectric constant of the existing insulating film such as SiO₂, which is 3.9 to 4.2. Accordingly, there is a technical effect that the withstand voltage characteristics are excellent even in high voltage or high frequency situations, thereby increasing the DEP force without destruction or damage, thereby improving the assembly rate.

In addition, in the second embodiment, the second semiconductor light emitting device (150N2) can be fixed on the first polarity zeta potential insulating layer (307) through the zeta potential, and together with this, there is a complex technical effect of a bonding force due to chemical bonding (COB) between the first polarity zeta potential insulating layer (307) and the second polarity zeta potential second insulating layer (122) of the second semiconductor light emitting device (150N2).

In addition, according to the embodiment, the problem of the assembly rate of the LED chip being affected by the weak DEP force in the assembly hole can be solved.

The technical effects of the embodiment are not limited to those described in this article, and can be understood through the entire specification..

### [Description of Drawings]

FIG. 1 is an example diagram of a living room of a house in which a display device according to an embodiment is placed.
FIG. 2 is a block diagram schematically showing a display device according to an embodiment.
FIG. 3 is a circuit diagram showing an example of a pixel of FIG. 2.
FIG. 4 is an enlarged view of a first panel area in the display device of FIG. 1.
FIG. 5 is a cross-sectional view along the line B1-B2 of the A2 area of FIG. 4.
FIG. 6 is an example diagram in which a light emitting device according to an embodiment is assembled to a substrate by a self-assembly method.
FIG. 7 is a diagram showing a tilt phenomenon that occurs during self-assembly of an internal technology.
FIG. 8 is a cross-sectional view of a display device (300) including a semiconductor light emitting device according to an embodiment.
FIG. 9 is a cross-sectional view of a semiconductor light emitting device (150N) employed in a display device (300) including a semiconductor light emitting device according to an embodiment.
Figs. 10 and 11 are photographs showing the detachment of a semiconductor light emitting device (15) in an assembly process of an internal technology.
Figs. 12 and 13 are photographs showing a state in which a semiconductor light emitting device (150N) is firmly fixed using a display device of a semiconductor light emitting device according to an embodiment.
FIG. 14 is an explanatory diagram of the fixing force of a semiconductor light emitting device and a zeta potential insulating layer of a first polarity according to an embodiment.
Figs. 15A and 15B are data on the zeta potential of a metal layer of a second polarity and an insulating layer of a zeta potential of a first polarity according to an embodiment.
FIG. 16 is an explanatory diagram of the fixing force of a semiconductor light emitting device and an insulating layer of a first polarity according to an embodiment.
FIG. 17 is a cross-sectional view of a semiconductor light emitting device (150N2) according to the second embodiment.
FIG. 18 is a drawing of a state in which the second semiconductor light emitting device is fixed on a zeta potential insulating layer of the first polarity according to the second embodiment.
FIG. 19 is an enlarged view of the fixed region in FIG. 18.
FIG. 20 is data on CH ion changes according to aging according to the embodiment.
FIG. 21 is a photograph showing a state in which the second semiconductor light emitting device (150N2) is firmly fixed using a display device of the semiconductor light emitting device according to the second embodiment.
FIG. 22 is a photograph of damage to the insulating layer in the aging process of the internal technology.

### [Mode for Invention]

Hereinafter, the embodiments disclosed in the present specification will be described in detail with reference to the attached drawings. The suffixes 'module' and 'part' used for components in the following description are given or used interchangeably for the sake of ease of specification writing, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is referred to as existing 'on' another element, this includes that it may be directly on the other element or that other intermediate elements may exist between them.

The display devices described in this specification may include digital TVs, mobile phones, smart phones, laptop computers, digital broadcasting terminals, PDAs (personal digital assistants), PMPs (portable multimedia players), navigations, slate PCs, tablet PCs, Ultra-Books, desktop computers, etc. However, the configuration according to the embodiment described in this specification can be applied to a new product type developed in the future, as well as a device capable of display.

The following describes a light emitting device according to the embodiment and a display device including the same.

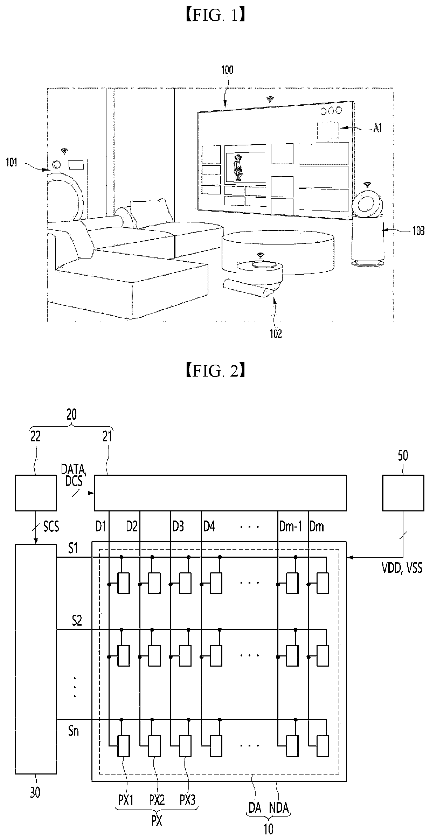

FIG. 1 illustrates a living room of a house in which a display device (100) according to the embodiment is placed.

The display device (100) according to the embodiment can display the status of various electronic products such as a washing machine (101), a robot cleaner (102), and an air purifier (103), and can communicate with each electronic product based on IoT and control each electronic product based on user setting data.

The display device (100) according to the embodiment can include a flexible display manufactured on a thin and flexible substrate. The flexible display can be bent or rolled like paper while maintaining the characteristics of a conventional flat panel display.

In a flexible display, visual information can be implemented by independently controlling the light emission of unit pixels disposed in a matrix form. A unit pixel means a minimum unit for implementing one color. A unit pixel of a flexible display can be implemented by a light emitting device. In an embodiment, the light emitting device may be a Micro-LED or a Nano-LED, but is not limited thereto.

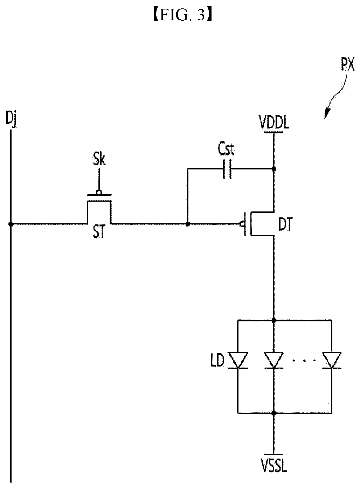

FIG. 2 is a block diagram schematically showing a display device according to an embodiment, and FIG. 3 is a circuit diagram showing an example of a pixel of FIG. 2.

Referring to FIGS. 2 and 3, a display device according to an embodiment may include a display panel (10), a driving circuit (20), a scan driving unit (30), and a power supply circuit (50).

The display device (100) of the embodiment may drive a light emitting device using an active matrix (AM) method or a passive matrix (PM) method.

The driving circuit (20) may include a data driving unit (21) and a timing control unit (22).

The display panel (10) may be divided into a display area (DA) and a non-display area (NDA) disposed around the display area (DA). The display area (DA) is an area where pixels (PX) are formed to display an image. The display panel (10) may include data lines (D1 to Dm, m is an integer greater than or equal to 2), scan lines (S1 to Sn, n is an integer greater than or equal to 2) intersecting the data lines (D1 to Dm), a high-potential voltage line to which a high-potential voltage is supplied, a low-potential voltage line to which a low-potential voltage is supplied, and pixels (PX) connected to the data lines (D1 to Dm) and the scan lines (S1 to Sn).

Each of the pixels (PX) may include a first sub-pixel (PX1), a second sub-pixel (PX2), and a third sub-pixel (PX3). The first sub-pixel (PX1) can emit a first color light of a first wavelength, the second sub-pixel (PX2) can emit a second color light of a second wavelength, and the third sub-pixel (PX3) can emit a third color light of a third wavelength. The first color light can be red light, the second color light can be green light, and the third color light can be blue light, but is not limited thereto. In addition, although FIG. 2 illustrates that each of the pixels (PXs) includes three sub-pixels, it is not limited thereto. That is, each of the pixels (PXs) can include four or more sub-pixels.

Each of the first sub-pixel (PX1), the second sub-pixel (PX2), and the third sub-pixel (PX3) can be connected to at least one of the data lines (D1 to Dm), at least one of the scan lines (S1 to Sn), and a high-potential voltage line. The first sub-pixel (PX1) may include light emitting devices (LD) and a plurality of transistors for supplying current to the light emitting devices (LD) and at least one capacitor (Cst), as shown in FIG. 3.

Although not shown in the drawing, each of the first sub-pixel (PX1), the second sub-pixel (PX2), and the third sub-pixel (PX3) may include only one light emitting device (LD) and at least one capacitor (Cst).

Each of the light emitting devices (LD) may be a semiconductor light-emitting diode including a first electrode, a plurality of conductivity type semiconductor layers, and a second electrode. Here, the first electrode may be an anode electrode, and the second electrode may be a cathode electrode, but is not limited thereto.

Referring to FIG. 3, the plurality of transistors may include a driving transistor (DT) for supplying current to the light emitting devices (LD), and a scan transistor (ST) for supplying a data voltage to a gate electrode of the driving transistor (DT). The driving transistor (DT) may include a gate electrode connected to the source electrode of the scan transistor (ST), a source electrode connected to a high-potential voltage line to which a high-potential voltage is applied, and a drain electrode connected to the first electrodes of the light emitting devices (LD). The scan transistor (ST) may include a gate electrode connected to a scan line (Sk, where k is an integer satisfying 1 ≤ k ≤ n), a source electrode connected to the gate electrode of the driving transistor (DT), and a drain electrode connected to a data line (Dj, where j is an integer satisfying 1 ≤ j ≤ m).

A capacitor (Cst) is formed between the gate electrode and the source electrode of the driving transistor (DT). The storage capacitor (Cst) may charge a difference value between the gate voltage and the source voltage of the driving transistor (DT).

The driving transistor (DT) and the scan transistor (ST) may be formed as thin film transistors. In addition, in FIG. 3, the driving transistor (DT) and the scan transistor (ST) are mainly formed as P-type MOSFETs (Metal Oxide Semiconductor Field Effect Transistors), but the present invention is not limited thereto. The driving transistor (DT) and the scan transistor (ST) may also be formed as N-type MOSFETs. In this case, the positions of the source electrodes and the drain electrodes of each of the driving transistor (DT) and the scan transistor (ST) may be changed.

In addition, in FIG. 3, the first sub-pixel (PX1), the second sub-pixel (PX2), and the third sub-pixel (PX3) are each exemplified as including 2T1C (2 Transistors - 1 capacitor) having one driving transistor (DT), one scan transistor (ST), and one capacitor (Cst), but the present invention is not limited thereto. The first sub-pixel (PX1), the second sub-pixel (PX2), and the third sub-pixel (PX3) each include a plurality of scan transistors (ST) and a plurality of capacitors (Cst).

Referring again to FIG. 2, the driving circuit (20) outputs signals and voltages for driving the display panel (10). To this end, the driving circuit (20) may include a data driving unit (21) and a timing control unit (22).

The data driving unit (21) receives digital video data (DATA) and a source control signal (DCS) from the timing control unit (22). The data driving unit (21) converts digital video data (DATA) into analog data voltages according to the source control signal (DCS) and supplies the same to the data lines (D1 to Dm) of the display panel (10).

The timing control unit (22) receives digital video data (DATA) and timing signals from the host system. The timing signals may include a vertical sync signal, a horizontal sync signal, a data enable signal, and a dot clock. The host system may be an application processor of a smartphone or tablet PC, a monitor, a system on chip of a TV, etc.

The scan driving unit (30) receives a scan control signal (SCS) from the timing control unit (22). The scan driving unit (30) generates scan signals according to the scan control signal (SCS) and supplies them to the scan lines (S1 to Sn) of the display panel (10). The scan driving unit (30) may include a plurality of transistors and may be formed in a non-display area (NDA) of the display panel (10). Alternatively, the scan driving unit (30) may be formed as an integrated circuit, in which case it may be mounted on a gate flexible film attached to the other side of the display panel (10).

The power supply circuit (50) can generate a high-potential voltage (VDD) and a low-potential voltage (VSS) for driving the light emitting devices (LD) of the display panel (10) from the main power supply and supply them to the high-potential voltage line and the low-potential voltage line of the display panel (10). In addition, the power supply circuit (50) can generate and supply driving voltages for driving the driving circuit (20) and the scan driving unit (30) from the main power supply.

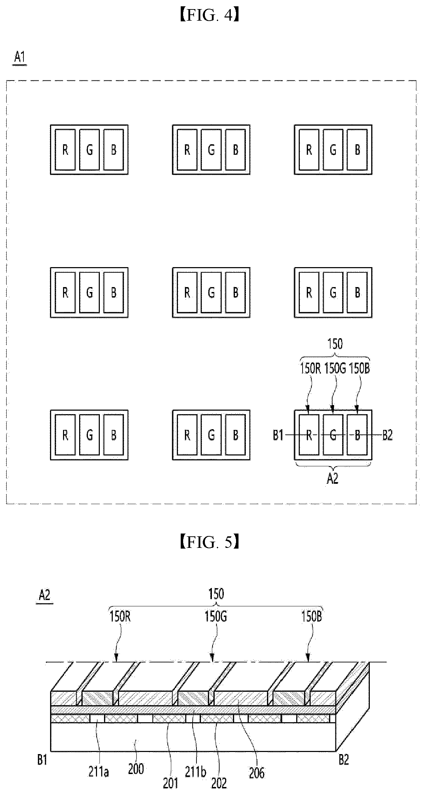

FIG. 4 is an enlarged view of the first panel area (A1) in the display device of FIG. 1.

According to FIG. 4, the display device (100) of the embodiment can be manufactured by mechanically and electrically connecting a plurality of panel areas such as the first panel area (A1) by tiling.

The first panel area (A1) can include a plurality of light emitting devices (150) disposed for each unit pixel (PX of FIG. 2).

For example, a unit pixel (PX) may include a first sub-pixel (PX1), a second sub-pixel (PX2), and a third sub-pixel (PX3). For example, a plurality of red light emitting devices (150R) may be disposed in a first sub-pixel (PX1), a plurality of green light emitting devices (150G) may be disposed in a second sub-pixel (PX2), and a plurality of blue light emitting devices (150B) may be disposed in a third sub-pixel (PX3). The unit pixel (PX) may further include a fourth sub-pixel in which no light emitting devices are disposed, but this is not limited thereto. Meanwhile, the light emitting device (150) may be a semiconductor light emitting device.

Next, FIG. 5 is a cross-sectional view along the line B1-B2 of the A2 region of FIG. 4.

Referring to FIG. 5, the display device (100) of the embodiment may include a substrate (200), an assembly wiring (201, 202), a first insulating layer (211a), a second insulating layer (211b), a third insulating layer (206), and a plurality of light emitting devices (150).

The assembly wiring may include a first assembly wiring (201) and a second assembly wiring (202) that are spaced apart from each other. The first assembly wiring (201) and the second assembly wiring (202) may be provided to generate a dielectric force for assembling the light emitting device (150). In addition, the first assembly wiring (201) and the second assembly wiring (202) may be electrically connected to an electrode of the light emitting device to function as an electrode of the display panel.

The assembly wiring (201, 202) may be formed of a light-transmitting electrode (ITO) or may include a metal material having excellent electrical conductivity. For example, the assembly wiring (201, 202) may be formed of at least one of titanium (Ti), chromium (Cr), nickel (Ni), aluminum (Al), platinum (Pt), gold (Au), tungsten (W), and molybdenum (Mo), or an alloy thereof.

A first insulating layer (211a) may be disposed between the first assembly wiring (201) and the second assembly wiring (202), and a second insulating layer (211b) may be disposed on the first assembly wiring (201) and the second assembly wiring (202). The first insulating layer (211a) and the second insulating layer (211b) may be an oxide film, a nitride film, or the like, but are not limited thereto.

The light emitting device (150) may include a red light emitting device (150), a green light emitting device (150G), and a blue light emitting device (150B0) to form a unit pixel (sub-pixel), but is not limited thereto, and may include a red fluorescent substance and a green fluorescent substance to implement red and green, respectively.

The substrate (200) may be formed of glass or polyimide. In addition, the substrate (200) may include a flexible material such as PEN (Polyethylene Naphthalate) or PET (Polyethylene Terephthalate). In addition, the substrate (200) may be a light-transmitting material, but is not limited thereto.

The third insulating layer (206) may include an insulating and flexible material such as polyimide, PEN, PET, etc., and may be formed integrally with the substrate (200) to form a single substrate.

The third insulating layer (206) may be a conductive adhesive layer having adhesiveness and conductivity, and the conductive adhesive layer may be flexible to enable a flexible function of the display device. For example, the third insulating layer (206) may be a conductive adhesive layer such as an anisotropic conductive film (ACF) or an anisotropic conductive medium, a solution containing conductive particles, etc. The conductive adhesive layer may be a layer that is electrically conductive in a vertical direction relative to the thickness, but electrically insulating in a horizontal direction relative to the thickness.

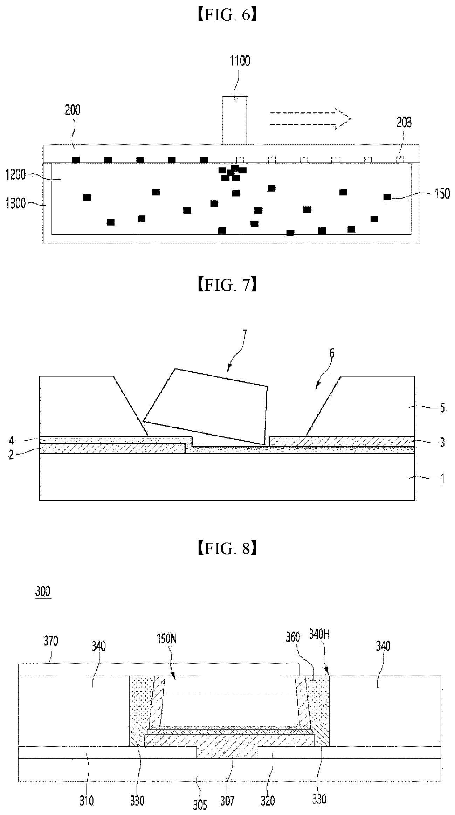

The third insulating layer (206) may include an assembly hole (203) for inserting a light emitting device (150) (see FIG. 6). Therefore, during self-assembly, the light emitting device (150) may be easily inserted into the assembly hole (203) of the third insulating layer

(206). The assembly hole (203) may be called an insertion hole, a fixing hole, an alignment hole, etc.

Between the assembly wirings (201, 202) The gap is formed smaller than the width of the light emitting device (150) and the width of the assembly hole (203), so that the assembly position of the light emitting device (150) can be fixed more precisely using an electric field.

A third insulating layer (206) is formed on the assembly wiring (201, 202), so as to protect the assembly wiring (201, 202) from the fluid (1200) and prevent leakage of current flowing through the assembly wiring (201, 202). The third insulating layer (206) can be formed as a single layer or multiple layers of an inorganic insulator such as silica or alumina or an organic insulator.

In addition, the third insulating layer (206) can include an insulating and flexible material such as polyimide, PEN, PET, etc., and can be formed integrally with the substrate (200) to form a single substrate.

The third insulating layer (206) may be an adhesive insulating layer or a conductive adhesive layer having conductivity. The third insulating layer (206) may be flexible to enable a flexible function of the display device.

The third insulating layer (206) may have a partition wall, and an assembly hole (203) may be formed by the partition wall. For example, when forming the substrate (200), a part of the third insulating layer (206) may be removed, so that each of the light emitting devices (150) may be assembled into the assembly hole (203) of the third insulating layer (206).

An assembly hole (203) in which the light emitting devices (150) are coupled is formed in the substrate (200), and a surface on which the assembly hole (203) is formed may be in contact with a fluid (1200). The assembly hole (203) may guide the exact assembly position of the light emitting devices (150).

Meanwhile, the assembly hole (203) may have a shape and size corresponding to the shape of the light emitting device (150) to be assembled at the corresponding position. Accordingly, it is possible to prevent another light emitting device from being assembled in the assembly hole (203) or a plurality of light emitting devices from being assembled.

FIG. 6 is a drawing showing an example in which a light emitting device according to an embodiment is assembled on a substrate by a self-assembly method, and the self-assembly method of the light emitting device is described with reference to the drawings.

The substrate (200) may be a panel substrate of a display device. In the following description, the substrate (200) is described as a panel substrate of a display device, but the embodiment is not limited thereto.

Referring to FIG. 6, a plurality of light emitting devices (150) may be introduced into a chamber (1300) filled with a fluid (1200). The fluid (1200) may be water such as ultrapure water, but is not limited thereto. The chamber may be called a tank, a container, a vessel, etc.

After this, the substrate (200) may be placed on the chamber (1300). Depending on the embodiment, the substrate (200) may be introduced into the chamber (1300).

As shown in FIG. 5, a pair of assembly wirings (201, 202) corresponding to each of the light emitting devices (150) to be assembled may be placed on the substrate (200).

Referring to FIG. 6, after the substrate (200) is placed, an assembly device (1100) including a magnetic body may move along the substrate (200). For example, a magnet or an electromagnet may be used as the magnetic body. The assembly device (1100) may move in contact with the substrate (200) to maximize the area to which the magnetic field is applied into the fluid (1200). Depending on the embodiment, the assembly device (1100) may include a plurality of magnetic bodies or may include a magnetic body of a size corresponding to the substrate (200). In this case, the movement distance of the assembly device (1100) may be limited within a predetermined range.

The light emitting device (150) in the chamber (1300) may move toward the assembly device (1100) by the magnetic field generated by the assembly device (1100).

While the light emitting device (150) is moving toward the assembly device (1100), it may enter the assembly hole (203) by the dielectrophoretic force (DEP force) and come into contact with the substrate (200).

Specifically, the assembly wiring (201, 202) forms an electric field by the power supplied from the outside, and the dielectrophoretic force may be formed between the assembly wiring (201, 202) by this electric field. By this dielectric force, the light emitting device (150) can be fixed to the assembly hole (203) on the substrate (200).

The light emitting device (150) in contact with the substrate (200) can be prevented from being detached by the movement of the assembly device (1100) by the electric field applied by the assembly wiring (201, 202) formed on the substrate (200). According to the embodiment, by the self-assembly method using the above-described electromagnetic field, the time required for each of the light emitting elements (150) to be assembled on the substrate (200) can be drastically shortened, so that a large-area, high-pixel display can be implemented more quickly and economically.

At this time, a predetermined solder layer (not shown) is formed between the light emitting device (150) assembled on the assembly hole (203) of the substrate (200) and the assembly electrode, thereby improving the bonding strength of the light emitting device (150).

Next, a molding layer (not shown) may be formed in the assembly hole (203) of the substrate (200). The molding layer may be a transparent resin or a resin containing a reflective material or a scattering material.

FIG. 7 is a drawing showing a tilt phenomenon that occurs during self-assembly according to the internal technology.

According to the internal technology, a dielectric layer (4) is disposed on the assembly electrodes (2, 3) on the assembly substrate (1), and self-assembly is performed by the dielectrophoretic force of the light emitting device (7) in the assembly hole (7) set by the assembly partition (5). However, according to the internal technology, the dielectrophoretic force is dispersed or weakened, so that self-assembly is not performed properly and the problem of tilting within the assembly hole (7) has been studied.

One of the technical objects of the embodiment is to solve the problem of the LED chip tilting or low assembly rate due to the DEP force in the assembly hole being weak.

Hereinafter, a semiconductor light emitting device display device according to an embodiment for solving a technical problem will be described with reference to the drawings.

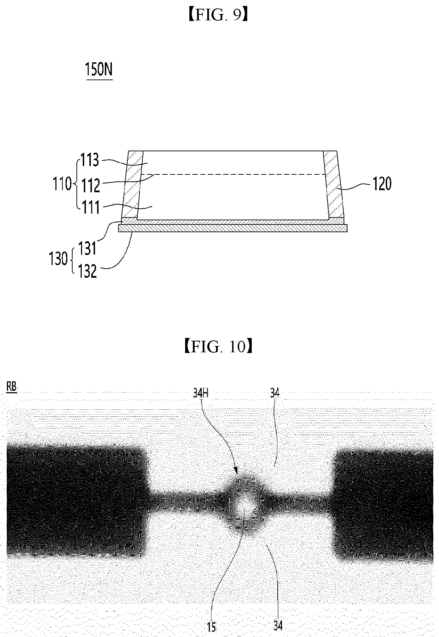

FIG. 8 is a cross-sectional view of a display device (300) including a semiconductor light emitting device according to an embodiment, and FIG. 9 is a cross-sectional view of a semiconductor light emitting device (150N) employed in a display device (300) including a semiconductor light emitting device according to an embodiment.

Referring to FIG. 8, a display device (300) having a semiconductor light emitting device according to an embodiment may include a substrate (305), a zeta potential insulating layer (307) having a first polarity, a first assembly electrode (310), a second assembly electrode (320), an assembly partition (340), and a semiconductor light emitting device (150N).

Specifically, a display device (300) having a semiconductor light emitting device according to an embodiment may include a substrate (305), a first assembly electrode (310) and a second assembly electrode (320) spaced apart from each other on the substrate (305), a zeta potential insulating layer (307) of a first polarity disposed on the first assembly electrode (310) and the second assembly electrode (320), a predetermined assembly hole (340H), an assembly partition (340) disposed on the first and second assembly electrodes (310, 320), and a semiconductor light emitting device (150N) disposed within the assembly hole (340H).

The zeta potential insulating layer (307) of the first polarity may include hydrogenated silicon carbide (SiCxH), but is not limited thereto.

In the embodiment, the first assembly electrode (310) or the second assembly electrode (320) may function as a pixel electrode in the panel.

Accordingly, the semiconductor light emitting device (150N) may be electrically connected to the first assembly electrode (310) or the second assembly electrode (320), but is not limited thereto.

For example, the embodiment may further include a side wiring (330) electrically connecting the first assembly electrode (310) or the second assembly electrode (320) and the semiconductor light emitting device (150N), but is not limited thereto.

The side wiring (330) may be electrically connected to the first conductivity type semiconductor layer (111) (see FIG. 9) of the semiconductor light emitting device (150N). For example, the side wiring (330) may be electrically connected to the first conductivity type semiconductor layer (111) of the semiconductor light emitting device (150N) through the second electrode layer (130), but is not limited thereto.

The side wiring (330) may be formed by removing a portion of the first polarity zeta potential insulating layer (307) after the self-assembly process to expose a portion of the upper side of the first assembly electrode (310) and the second assembly electrode (320), and then connecting the exposed first and second assembly electrodes (310, 320) and the second electrode layer (130).

In addition, the embodiment may include a light-transmitting resin (360) that fills the assembly hole (340H) and a second panel wiring (370) that is electrically connected to the semiconductor light emitting device (150N).

The second panel wiring (370) may be formed of a transparent electrode and may function as a common wiring for each pixel, but is not limited thereto.

For example, the second panel wiring (370) may be formed by including at least one of a light-transmitting member, such as ITO (indium tin oxide), IAZO (indium aluminum zinc oxide), IZO (indium zinc oxide), IZTO (indium zinc tin oxide), IGZO (indium gallium zinc oxide), IGTO (indium gallium tin oxide), AZO (aluminum zinc oxide), ATO (antimony tin oxide), GZO (gallium zinc oxide), IZON (IZO Nitride), AGZO (Al-Ga ZnO), and IGZO (In-Ga ZnO), but is not limited thereto.

In addition, the second panel wiring (370) may include an ohmic metal layer.

The semiconductor light emitting device (150N) according to the embodiment will be described with reference to FIG. 9 for a moment.

Referring to FIG. 9, the semiconductor light emitting device (150N) according to the embodiment can be implemented as a vertical semiconductor light-emitting device as shown, but is not limited thereto, and a horizontal light-emitting device can be employed.

The semiconductor light emitting device (150N) may include a light emitting structure (110), a second electrode layer (130), and a passivation layer (120).

For example, the semiconductor light emitting device (150N) may include a second electrode layer (130) disposed under the light emitting structure (110) and a passivation layer (120) disposed on a portion of the upper surface and side surface of the light emitting structure (110).

In addition, the semiconductor light emitting device (150N) may further include a first electrode layer (not shown) on the upper surface of the light emitting structure (110), but is not limited thereto.

The light emitting structure (110) may include a first conductivity type semiconductor layer (111), a second conductivity type semiconductor layer (113), and an active layer (112) disposed therebetween. The first conductivity type semiconductor layer (111) may be an n-type semiconductor layer, and the second conductivity type semiconductor layer (113) may be a p-type semiconductor layer, but is not limited thereto.

The first conductivity type semiconductor layer (111), the active layer (112), and the second conductivity type semiconductor layer (113) may be formed of a compound semiconductor material. For example, the compound semiconductor material may be a group III-V compound semiconductor material, a group II-VI compound material, etc. For example, the compound semiconductor material may include GaN, InGaN, AlN, AlInN, AlGaN, AlInGaN, InP, GaAs, GaP, GaInP, etc.

For example, the first conductivity type semiconductor layer (111) may include a first conductivity type dopant, and the second conductivity type semiconductor layer (113) may include a second conductivity type dopant. For example, the first conductivity type dopant may be an n-type dopant such as silicon (Si), and the second conductivity type dopant may be a p-type dopant such as boron (B).

The active layer (112) is a region that generates light, and may generate light having a specific wavelength band according to the material properties of the compound semiconductor. That is, the wavelength band may be determined by the energy bandgap of the compound semiconductor included in the active layer (112). Therefore, depending on the energy band gap of the compound semiconductor included in the active layer (112), the semiconductor light emitting device (110) of the embodiment can generate UV light, blue light, green light, and red light.

Next, the second electrode layer (130) may include a metal having excellent electrical conductivity. The second electrode layer (130) may include a metal layer (132). For example, the second electrode layer (130) may include one or more metal layers (132) of Ti, Sn, In, Cr, etc., but is not limited thereto.

The metal layer (132) may be a zeta potential metal layer of the second polarity.

In addition, the second electrode layer (130) may be provided with a magnetic layer (131). The magnetic layer (131) may be provided on the lower side of the light emitting structure (110). The above magnetic layer (131) may include any one of nickel, cobalt, iron or neodymium magnets.

Next, the passivation layer (120) may be formed by an inorganic insulator such as silica or alumina through PECVD, LPCVD, sputtering deposition, etc. After the semiconductor light emitting device (150N) is assembled on the assembly substrate (200), a portion of the upper layer of the passivation layer (120) may be etched during the manufacturing process of the display device.

Referring again to FIG. 8, a display device (300) having a semiconductor light emitting device according to an embodiment may include a zeta potential insulating layer (307) of a first polarity between the first and second assembly electrodes (310, 320) and the semiconductor light emitting device (150N).

One of the technical objects of the embodiment is to solve the problem that when the power is cut off to the assembly electrode after assembly using DEP force and there is no DEP force, the fixing force between the semiconductor light emitting device and the dielectric layer on the assembly electrode is weak, resulting in the detachment of the semiconductor light emitting device assembled in the assembly hole.

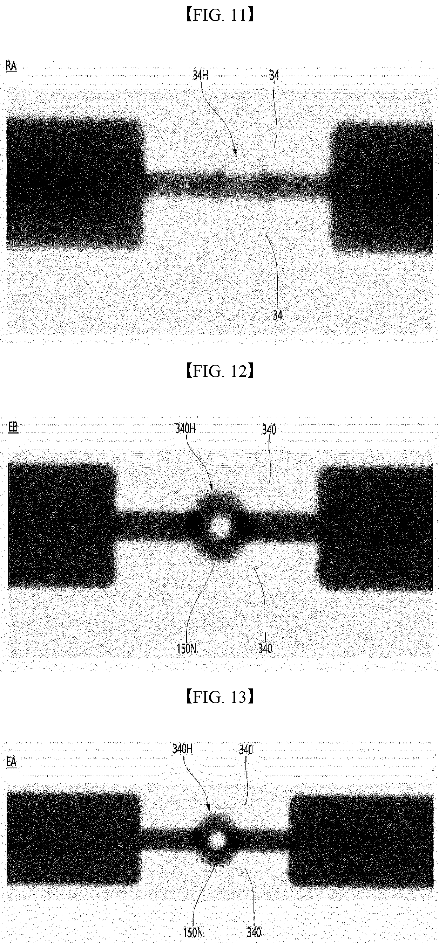

First, FIG. 10 and FIG. 11 are photographs showing the detachment of the semiconductor light emitting device (15) in the assembly process of the internal technology.

For example, FIG. 10 is a state (RB) in which the semiconductor light emitting device (15) is assembled in the assembly hole (34H) of the assembly partition (34) using the DEP force according to the internal technology.

Next, FIG. 11 is a photograph of a state (RA) in which a semiconductor light emitting device (15) is detached from an assembly hole (34H) as the fluid in the tank is emptied while the power to the assembly electrode is cut off.

As shown in FIG. 11, according to the internal technology, a process of draining the fluid in the tank is performed after assembly using the DEP force, and at this time, if the power to the assembly electrode is cut off and there is no DEP force, the fixing force between the semiconductor light emitting device (15) and the dielectric layer on the assembly electrode is weak, so the fluid draining process takes tens of minutes or more, and furthermore, even if slow draining is performed, a problem occurs in which the semiconductor light emitting device assembled in the assembly hole is detached.

In addition, according to the internal technology, when the electrode process of the panel unit is performed after assembly using the DEP force, if the power to the assembly electrode is cut off and there is no DEP force, the fixing force between the semiconductor light emitting device and the dielectric layer on the assembly electrode is weak, so the semiconductor light emitting device assembled in the assembly hole is detached.

To solve this problem, internal technology has conducted research to fix the LED chip by filling the space between the lower part of the LED chip and the lower assembly electrode with a chip fixing organic film such as PR using capillary phenomena. However, there is a problem of poor coating in the organic film coating process, and the chip detachment problem has not been completely solved.

On the other hand, FIGS. 12 and 13 are photographs showing a state in which a semiconductor light emitting device (150N) is firmly fixed using a display device of a semiconductor light emitting device according to an embodiment.

For example, FIG. 12 is a state (EB) in which a semiconductor light emitting device (150N) is assembled into an assembly hole (340H) of an assembly partition (340) using DEP force according to a display device of a semiconductor light emitting device according to an embodiment.

Next, FIG. 13 is a photograph showing a state (EA) in which a semiconductor light emitting device (150N) is firmly fixed in an assembly hole (340H) even when the fluid in the tank is emptied while the power to the assembly electrode is cut off.

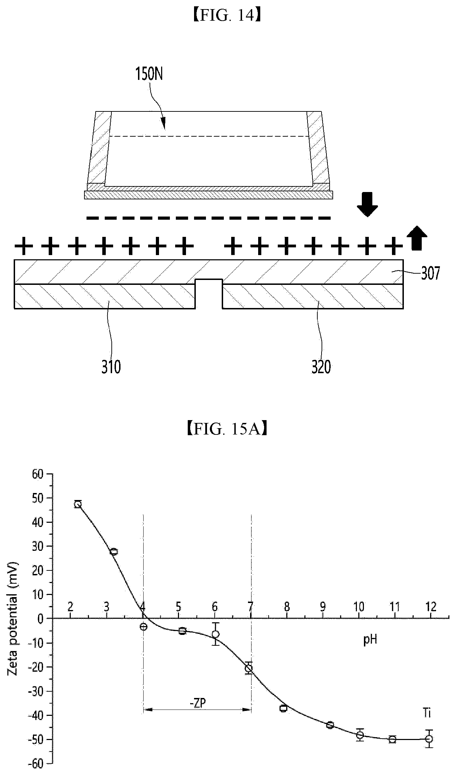

The technical features according to the embodiment will be described with reference to FIGS. 14 to 16.

FIG. 14 is a diagram explaining the fixing force of the semiconductor light emitting device (150N) and the first polarity zeta potential insulating layer (307) in the embodiment.

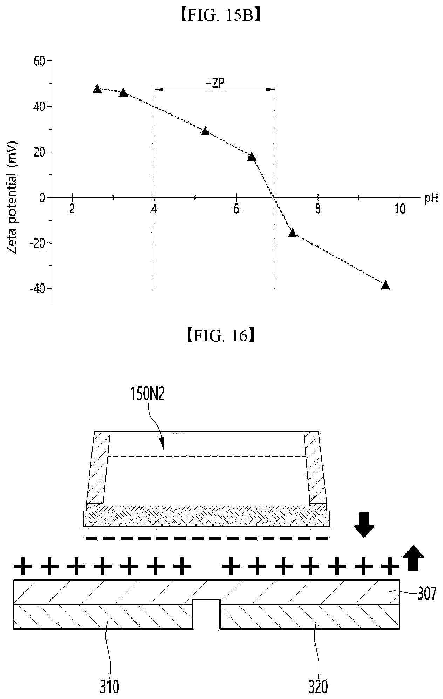

In addition, FIGS. 15A and 15B are data on the zeta potential of the second polarity metal layer (132) and the first polarity zeta potential insulating layer (307) in the embodiment.

Referring to FIG. 14, the display device (300) having the semiconductor light emitting device according to the embodiment may include the first polarity zeta potential insulating layer (307) between the first and second assembly electrodes (310, 320) and the semiconductor light emitting device (150N). The first polarity zeta potential insulating layer (307) may include, but is not limited to, hydrogenated silicon carbide (SiCxH).

For example, referring to FIG. 15B, the first polarity zeta potential insulating layer (307) may have a positive (+) zeta potential at pH 4 to 7.

On the other hand, referring to FIG. 9, the second electrode layer (130) of the semiconductor light emitting device (150N) may include a second polarity zeta potential metal layer (132). For example, the second polarity zeta potential metal layer (132) may be Ti, but is not limited thereto.

For example, referring to FIG. 15A, the second polarity zeta potential metal layer (132) may have a negative (-) zeta potential at pH 4 to 7.

According to an embodiment, a first polarity zeta potential insulating layer (307) is disposed between the first and second assembly electrodes (310, 320) and the semiconductor light emitting device (150N), and a second polarity zeta potential metal layer (132) is included in the semiconductor light emitting device (150N), so that the fixing force on the first polarity zeta potential insulating layer (307) of the semiconductor light emitting device (150N) can be significantly improved.

For example, the first polarity zeta potential insulating layer (307) can be controlled to have a positive (+) zeta potential and the metal layer can be controlled to have a negative (-) zeta potential, so that the value of the overall zeta potential can be controlled to be close to zero. Accordingly, the semiconductor light emitting device (150N) can be condensed on the first polarity zeta potential insulating layer (307), so that the fixing force between them can be significantly improved.

In addition, in the embodiment, the dielectric constant of the first polarity zeta potential insulating layer (307) disposed on the first and second assembly electrodes (310, 320) may be at least twice as high as that of an existing insulating film such as SiO₂. For example, the dielectric constant of the first polarity zeta potential insulating layer (307) in the embodiment may be about 8 to 14, which may be at least twice as high as that of an existing insulating film such as SiO₂, which is at least 3.9 to 4.2.

Accordingly, according to the embodiment, the dielectric constant of the first polarity zeta potential insulating layer (307) disposed on the first and second assembly electrodes (310, 320) is set to be at least twice as high as that of the conventional insulating film, thereby significantly improving the DEP force, thereby significantly improving the positive assembly rate. In addition, the first polarity zeta potential insulating layer (307) is controlled to have a positive (+) zeta potential and the metal layer has a negative (-) zeta potential, thereby allowing the semiconductor light emitting device (150N) to be aggregated on the first polarity zeta potential insulating layer (307) and significantly improving the fixing force between them, which has a complex technical effect.

In addition, the fixing force between the first polarity zeta potential insulating layer (307) and the metal layer (132) in the embodiment can have sufficient bonding force to withstand the magnetic force by the magnet and the impact of other LED chips in the state where the electric field is turned off.

Next, in order to increase the DEP force in the internal technology and improve the assembly strength and fixing strength, an attempt was made to increase the voltage or frequency, but due to this attempt, damage occurred to the insulating layer or the assembly barrier due to damage to the existing SiO₂ series insulating film.

On the other hand, in the embodiment, the dielectric constant of the first polarity zeta potential insulating layer (307) disposed on the first and second assembly electrodes (310, 320) may be at least twice as high as that of the existing SiO₂ insulating film. For example, the dielectric constant of the first polarity zeta potential insulating layer (307) in the actual example may be about 8 to 14, which may be at least twice as high as that of the existing SiO₂ insulating film, which is at least 3.9 to 4.2.

Accordingly, there is a technical effect that the DEP force can be increased to improve the assembly rate without destruction or damage due to excellent withstand voltage characteristics even in high voltage or high frequency situations.

Next, FIG. 16 is a diagram explaining the fixing force of the semiconductor light emitting device (150N2) and the first polarity zeta potential insulating layer (307) in the second embodiment.

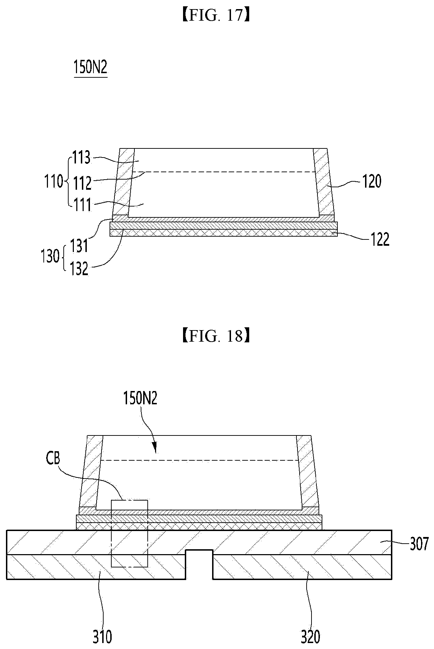

FIG. 17 is a cross-sectional view of the semiconductor light emitting device (150N2) according to the second embodiment.

The second embodiment may adopt the technical features of the previously described embodiment, and the main features of the second embodiment will be described below.

Referring to FIG. 16, the display device (300) having the semiconductor light emitting device according to the second embodiment may include a first polarity zeta potential insulating layer (307) between the first and second assembly electrodes (310, 320) and the second semiconductor light emitting device (150N2). The first polarity zeta potential insulating layer (307) may include hydrogenated silicon carbide (SiCxH), but is not limited thereto.

For example, the first polarity zeta potential insulating layer (307) may have a positive (+) zeta potential at pH 4 to 7.

Next, referring to FIG. 17, the second electrode layer (130) of the second semiconductor light emitting device (150N2) may include a second polarity zeta potential metal layer (132). For example, the second polarity zeta potential metal layer (132) may be Ti, but is not limited thereto. For example, the second polarity zeta potential metal layer (132) may have a negative (-) zeta potential at pH 4 to 7.

At this time, the second semiconductor light emitting device (150N2) may include a second polarity zeta potential second insulating layer (122) under the second polarity zeta potential metal layer (132).

For example, the second polarity zeta potential second insulating layer (122) may be a nitride film or an oxide film. For example, the second polarity zeta potential second insulating layer (122) may be a Si3N4 layer or a SiO₂ layer, but is not limited thereto.

At this time, since the second polarity zeta potential second insulating layer (122) has a second polarity zeta potential, it may be optional for the metal layer (132) to have a second polarity zeta potential.

Referring to FIG. 16, in the second embodiment, a first polarity zeta potential insulating layer (307) is disposed between the first and second assembled electrodes (310, 320) and the second semiconductor light emitting device (150N2), and a second polarity zeta potential second insulating layer (122) is included in the second semiconductor light emitting device (150N2), so that the fixing force on the first polarity zeta potential insulating layer (307) of the second semiconductor light emitting device (150N2) can be significantly improved.

In addition, in the second embodiment, since a first polarity zeta potential insulating layer (307) is disposed between the first and second assembled electrodes (310, 320) and the second semiconductor light emitting device (150N2), and by including a second polarity zeta potential second insulating layer (122) and a second polarity metal layer (132) in a semiconductor light emitting device (150N2), the fixing force on the first polarity zeta potential insulating layer (307) of the second semiconductor light emitting device (150N2) can be significantly improved.

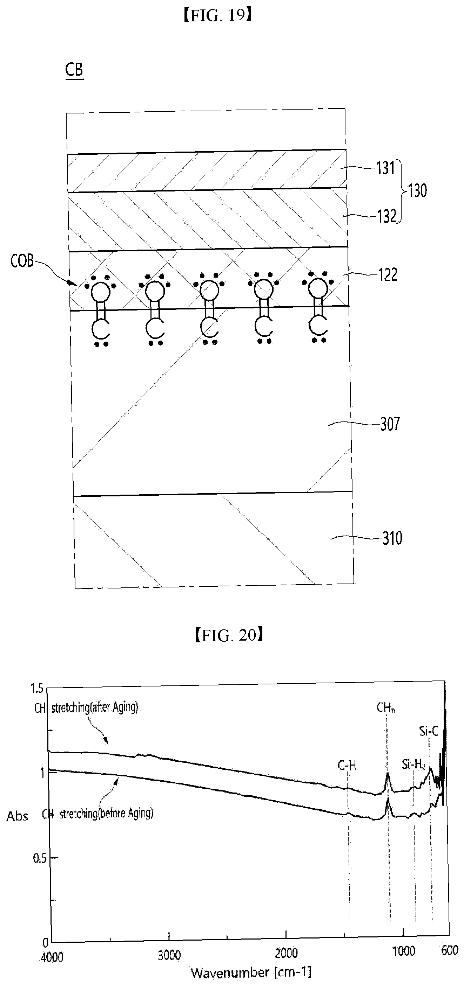

Next, FIG. 18 is a drawing of a state of fixing on the first polarity zeta potential insulating layer (307) of the second semiconductor light emitting device (150N2) in the second embodiment, and FIG. 19 is an enlarged view of the fixing area (CB) in FIG. 18.

Referring to FIG. 18 and FIG. 19, in the second embodiment, the second semiconductor light emitting device (150N2) can be fixed on the zeta potential insulating layer (307) of the first polarity through the zeta potential, and together with this, there is a complex technical effect of a bonding force by chemical bonding (COP) between the zeta potential insulating layer (307) of the first polarity and the zeta potential second insulating layer (122) of the second semiconductor light emitting device (150N2).

FIG. 20 is data of CH ion changes according to aging in the embodiment.

According to the second embodiment, after being assembled by the DEP force, the zeta potential insulating layer (307) of the first polarity can be aged using the first and second assembly electrodes (310, 320), and accordingly, CH ions can be formed on the surface of the zeta potential insulating layer (307) of the first polarity.

In the second embodiment, aging can be performed for about 10 minutes or more at an AC voltage 2 to 2.5 times the assembly condition for the DEP force, for example, 20 V or more, immediately after assembly with the DEP force.

Referring to FIG. 20, it can be seen that CH stretching significantly increases after aging compared to before aging.

According to the second embodiment, there is a technical effect in which the bonding force is improved by chemical bonding (COB) between carbon on the surface of the aged first polarity zeta potential insulating layer (307) and oxygen or nitrogen of the second polarity zeta potential second insulating layer (122) of the second semiconductor light emitting device (150N2).

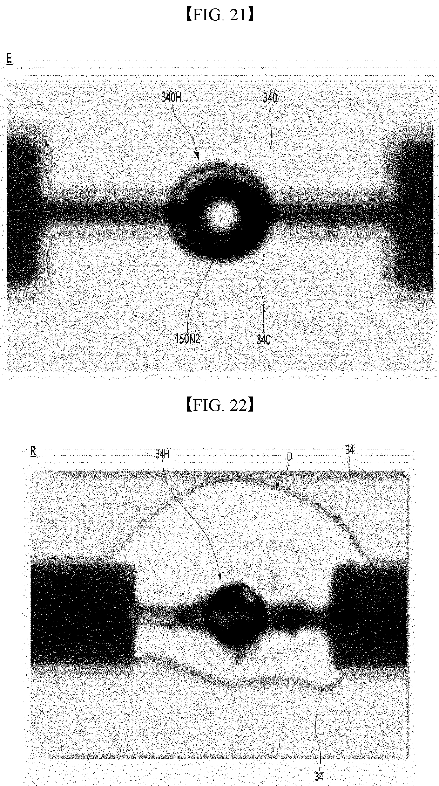

FIG. 21 is a photograph showing a state in which the second semiconductor light emitting device (150N2) is firmly fixed using a display device of a semiconductor light emitting device according to the second embodiment, and FIG. 22 is a photograph of damage to the insulating layer in the aging process of the internal technology.

Referring to FIG. 22, in the case where the insulating layer on the assembled electrode in the internal technology was aged in the case of the existing SiO₂ series insulating film, damage (D) occurred in the insulating layer or the assembled barrier due to the damage to the existing SiO₂ series insulating film.

For example, in the case where the insulating layer on the assembled electrode in the internal technology was aged for about 10 minutes or more at an AC voltage 2 to 2.5 times higher than the assembly condition for the DEP force, for example, 20 V or higher, immediately after the DEP assembly, the existing SiOx insulating film suffered damage (d) due to the relatively high voltage.

On the other hand, referring to FIG. 21, in the embodiment, the dielectric constant of the first polarity zeta potential insulating layer (307) disposed on the first and second assembled electrodes (310, 320) may be at least twice as high as that of the existing SiO₂ or other insulating film. Accordingly, since the film density and chemical resistance of the first polarity zeta potential insulating layer (307) are good, there is a technical effect that the film is not damaged even at high voltage. Therefore, if aging is performed for about 10 minutes or more at an AC voltage 2 to 2.5 times higher than the assembly condition for DEP force immediately after DEP assembly, for example, 20 V or higher, the aging can be performed without destruction or damage even in a high voltage or high frequency aging situation because the contact pressure resistance is excellent, and CH stretching is significantly increased after aging compared to before aging.

In addition, according to the second implementation, there is a technical effect that the bonding strength is improved by chemical bonding (COB) between carbon on the surface of the aged first polarity zeta potential insulating layer (307) and oxygen or nitrogen of the second polarity zeta potential insulating layer (122) of the second semiconductor light emitting element (150N2).

Meanwhile, in the second embodiment, aging is applied to the first polarity zeta potential insulating layer (307), and the second polarity zeta potential second insulating layer (122) of the second semiconductor light emitting device (150N2) may not be directly affected, and thus, damage to the first polarity zeta potential insulating layer (307) may be controlled so as not to occur.

The above detailed description should not be construed as restrictive in all respects and should be considered exemplary. The scope of the embodiment should be determined by a reasonable interpretation of the appended claims, and all changes within the equivalent scope of the embodiment are included in the scope of the embodiment.

### [Industrial Applicability]

The embodiment can be adopted in the field of displays that display images or information.

The embodiment can be adopted in the field of displays that display images or information using semiconductor light emitting devices.

The embodiment can be adopted in the display field that displays images or information using micro-level or nano-level semiconductor light emitting devices.

## Claims

1. A display device including a semiconductor light emitting device, comprising:
a substrate;
a first assembly electrode and a second assembly electrode disposed to be spaced apart from each other on the substrate;
a first polarity zeta potential insulating layer disposed on the first and second assembly electrodes;
an assembly partition wall disposed with an assembly hole disposed on the first and second assembly electrodes; and
a semiconductor light emitting device disposed in the assembly hole,
wherein the semiconductor light emitting device comprises a metal layer having a second polarity zeta potential.

2. The display device including the semiconductor light emitting device according to the claim 1, wherein the first polarity zeta potential insulating layer comprises hydrogenated silicon carbide.

3. The display device including the semiconductor light emitting device according to the claim 1, wherein the zeta potential insulating layer (307) of the first polarity has a positive (+) zeta potential.

4. The display device including the semiconductor light emitting device according to the claim 1, wherein the zeta potential metal layer (132) of the second polarity has a negative (-) zeta potential.

5. The display device including the semiconductor light emitting device according to the claim 1, wherein the zeta potential insulating layer (307) of the first polarity has a dielectric constant of 8 to 14.

6. A display device including a semiconductor light emitting device, comprising:
a substrate;
a first assembly electrode and a second assembly electrode spaced apart from each other on the substrate;
a first polarity zeta potential insulating layer disposed on the first and second assembly electrodes;
an assembly partition wall disposed with an assembly hole disposed on the first and second assembly electrodes; and
a semiconductor light emitting device disposed within the assembly hole,
wherein the semiconductor light emitting device comprises a second insulating layer having a zeta potential of a second polarity.

7. The display device including the semiconductor light emitting device according to the claim 6, wherein the second insulating layer having a zeta potential of the second polarity comprises a nitride film or an oxide film.

8. The display device including the semiconductor light emitting device according to the claim 7, further including a metal layer having a zeta potential of a second polarity.

9. The display device including the semiconductor light emitting device according to the claim 8, wherein the second insulating layer having a zeta potential of the second polarity is disposed between the metal layer having a zeta potential of the second polarity and the insulating layer having a zeta potential of the first polarity.

10. The display device including the semiconductor light emitting device according to any one of the claims 6 to 9, wherein the first polarity zeta potential insulating layer comprises hydrogenated silicon carbide.
